# EUROPÄISCHE PATENTANMELDUNG

(11) **EP 4 290 250 A1**
(43) Veröffentlichungstag der Anmeldung: **13.12.2023**
(21) Anmeldenummer: 22177774.1
(22) Anmeldetag: 08.06.2022
(51) Int. Cl.: G01R 31/26, G01N 29/04, G01N 29/09

(54) **VERFAHREN ZUR PRÜFUNG EINER ELEKTRONISCHEN BAUGRUPPE SOWIE ELEKTRONISCHEN BAUGRUPPE MIT VORRICHTUNG ZUR PRÜFUNG**

(71) Anmelder: Siemens Aktiengesellschaft, 80333 München (DE)
(72) Erfinder: Kriegel, Kai, 81739 München (DE); Mitic, Gerhard, 81827 München (DE); Stegmeier, Stefan, 81825 München (DE); Walbrecker-Baar, Christian, 85757 Karlsfeld (DE)
(74) Vertreter: Siemens Patent Attorneys

(57) **Zusammenfassung**

Es wird ein Verfahren zur Qualitätsprüfung und eine leistungselektronische Baugruppe (10) angegeben, welche ausgestaltet ist, das Verfahren auszuführen. Bei der leistungselektronischen Baugruppe (10) handelt es sich insbesondere um einen Schaltungsträger.

Erfindungsgemäß wird wenigstens ein Bauteil (50, 60) des Schaltungsträgers (10) mittels eines elektrischen Charakterisierungsverfahrens untersucht, wobei das untersuchte Bauteil (50, 60) mittels Ultraschallwellen (110) derart angeregt wird, dass dadurch Veränderungen im Signal des elektrischen Charakterisierungsverfahrens verursacht werden, welche Signaländerungen mittels einer Signalanalyse (210) ausgewertet werden um daraus Schlüsse auf materielle Änderungen am Bauteil (50, 60) zu ziehen.

## Beschreibung

Die Erfindung betrifft ein Verfahren zur Prüfung einer elektronischen Baugruppe sowie eine elektronische Baugruppe mit Vorrichtung zur Ausführung eines solchen Verfahrens.

Bei der Fertigung elektronischer Baugruppen, insbesondere nach der Bestückung von Schaltungsträgern für elektronische Baugruppen, bleibt eine Qualitätskontrolle der elektronischen Baugruppe auf Fertigungsfehler zu unternehmen. Regelmäßig auftretende Fertigungsfehler sind Defekte. Solche Defekte sind insbesondere großflächige Lunker in Lötverbindungen, Leiterplattenverwölbungen, unzureichende Lötstellenkontaktierungen, Delaminationen von Leitermaterialien in Leiterplatten, Flussmittelrückstände, Chipverdrehungen sowie mangelhafte Laserschweißverbindungen von metallischen Lastanschlüssen.

Es ist bekannt, elektronische Baugruppen, wie insbesondere bestückte Schaltungsträger, mittels optischer Bildgebung und/oder elektrischer Prüfung auf mögliche Defekte zu untersuchen. Allerdings ist eine optische Qualitätskontrolle mittels automatisierter Bildgebung hinsichtlich einiger Defekte noch nicht hinreichend zuverlässig. Insbesondere Leiterplattenverwölbungen sind mittels optischer Bildgebung nur schwer zu erkennen.

Auch großflächige Lunker, Delaminationen von Leitermaterialen in Leiterplatten sowie mangelhafte Laserschweißverbindungen von metallischen Lastanschlüssen lassen sich optisch und elektrisch noch nicht hinreichend zuverlässig erkennen.

Aber auch im Betrieb elektronischer Baugruppen, insbesondere leistungselektronischer Baugruppen, bleibt eine Qualitätskontrolle erforderlich, da betriebsbedingte beziehungsweise alterungsbedingte Fehler auftreten. Vor allem durch betriebsbedingte Temperaturzyklen altern leistungselektronische Systeme wie beispielsweise Leistungsmodule. Thermisch stark belastete leistungselektronische Systeme und deren Leistungsschaltmodule, beispielsweise IGBT-Module, unterliegen einer merklichen Alterung durch den normalen Betrieb innerhalb ihrer spezifizierten Betriebsgrenzen IGBT-Module werden etwa in leistungselektronischen Umrichtern eingesetzt.

Diese Alterung wird hauptsächlich durch eine hohe Zahl von Lastzyklen der Betriebserwärmung und -abkühlung hervorgerufen, die zur allmählichen Zerstörung von Chiplotschichten unter den Halbleiterchips und zur Ermüdung von Bonddrähten und Chipmetallisierungen führen, die den Strom in die schaltenden und gleichrichtenden Chips leiten. Typische Fehlermechanismen sind der Bond Lift-Off, das heißt das Abheben bis hin zum Riss des Bonddrahtes, der Heel-Crack und die Lotermüdung von Chip- und Systemlot, welches das unterliegende Lot des Keramikträgers umfasst. Ein Problem ist unter anderem, dass der Zeitpunkt eines Ausfalles so stark und in so komplizierter Weise von den vergangenen Belastungen abhängt, dass auch fortgeschrittene Vorhersagemodelle sehr ungenau sind.

Daneben finden auch Alterungen in der Chip-Peripherie aufgrund der Temperaturschwankungen statt. So kann einerseits der Schaltungsträger (DCB, AMB) aufgrund der unterschiedlichen Ausdehnungskoeffizienten (Keramik/Kupfer) über einem Muschelbruch zerstört werden und andererseits die darüberliegenden Treiberansteuerung, insbesondere bei zukünftigen integrierten Leistungsmodulen.

Heute werden beispielsweise modellbasierte Schätzverfahren eingesetzt, die aber sehr ungenau sind. Eine weitere Möglichkeit ist die Impedanzspektroskopie, bei der die thermische Impedanz des Modulaufbaus bestimmt wird. Hierbei wird ein elektronischer Schalter als Heizelement und als Sensor genutzt. Diese Messung kann nur durchgeführt werden, wenn das System nicht im Betrieb ist. Ein weiterer Ansatz ist die Verzerrungsmessung mit elektrischer Anregung, die durch Grenzflächen und Übergänge entstehen. Diese Messungen werden mit Hochfrequenzsignalen auch im Betrieb durchgeführt. Die Ergebnisse bedürfen einer Interpretation, weil die Signale sehr klein sind.

In schwer zugänglichen oder dauerbetriebenen Einsatzgebieten, in denen ein Ausfall eines Umrichters unbedingt vermieden werden muss, z.B. Windumrichter off-shore oder bei Traktionsanwendungen, gibt es heute verschiedene Lösungswege, einen überraschenden Betriebsstillstand weitestgehend organisatorisch zu vermeiden. So kann durch Redundanz der Leistungselektronik oder durch Maßnahmen auf der Wartungsebene, etwa durch präventiven Austausch der Leistungsmodule, spontanen Stillständen begegnet werden.

Mit Hilfe von fortgeschrittenen thermischen Modellen auf Basis von vorherigen, beschleunigten Lebensdauerprüfungen kann dabei auf die zu erwartende und die bereits verbrauchte Lebensdauer geschlossen werden. Aufgrund der hohen Komplexität der Abhängigkeiten sind diese Berechnungen jedoch nach wie vor mit sehr großen Fehlern behaftet.

Von einigen Leistungsmodulherstellern werden IGBT-Leistungsschaltmodule angeboten, in deren IGBTs kleine Messdioden als Temperatursensor integriert sind. Über die wachsende Temperaturerhöhung des IGBTs bei gegebenem Betriebsstrom lässt sich dann indirekt auf eine (Lot-) Alterung schließen. Dies geht jedoch mit Chipflächeneinbußen und höheren Chipkosten einher.

Vor diesem Hintergrund des Standes der Technik ist es daher Aufgabe der Erfindung, ein verbessertes Verfahren zur Prüfung einer elektronischen Baugruppe sowie eine elektronische Baugruppe mit Vorrichtung zur Ausführung dieses verbesserten Verfahrens zu schaffen. Insbesondere soll mit dem erfindungsgemäßen Verfahren zur Prüfung einer elektronischen Baugruppe eine einfache, kostengünstige und zuverlässige Prüfung der elektronischen Baugruppe möglich sein.

Diese Aufgabe der Erfindung wird mit einem Verfahren zur Prüfung einer elektronischen Baugruppe mit den in Anspruch 1 angegebenen Merkmalen sowie mit einer elektronischen Baugruppe mit Vorrichtung zur Ausführung eines solchen Verfahrens zur Prüfung mit den in Anspruch 11 angegebenen Merkmalen gelöst.

Bevorzugte Weiterbildungen der Erfindung sind in den zugehörigen Unteransprüchen, der nachfolgenden Beschreibung und der Zeichnung angegeben.

Das erfindungsgemäße Verfahren zur Qualitätsprüfung einer leistungselektronischen Baugruppe, umfasst die Untersuchung wenigstens eins Bauteils der leistungselektronischen Baugruppe mittels eines elektrischen Charakterisierungsverfahrens, bei dem das untersuchte Bauteil mittels Ultraschallwellen derart angeregt wird, dass dadurch Veränderungen im Signal des elektrischen Charakterisierungsverfahrens verursacht werden. Die ultraschallbedingten Veränderungen des elektrischen Signals werden mittels einer Signalanalyse ausgewertet. Dadurch werden materielle Änderungen am Bauteil indiziert.

Das erfindungsgemäße Verfahren realisiert demnach eine Zustandsüberwachung, auf der eine Restlebensdauerbestimmung basieren kann. Es werden ungeplante Ausfälle vermieden und eine vorausschauende Wartung ermöglicht. Des Weiteren ergibt sich der Vorteil eine kommerzielle Lösung für die Zustandsüberwachung von gesamten Leistungsmodulen in Umrichtern anbieten zu können, die im Hinblick auf eine Lebensdauerprognose nutzbar ist. Die durch die angegebene Qualitätskontrolle vorteilhaft zu detektierenden Fehler sind insbesondere Defekte, wie beispielsweise Materialdefekte, die nach der Herstellung aber besonders alterungsbedingt auftreten können. Insbesondere durch zu hohe Bauteiltemperaturen und besonders durch Temperaturwechsel, werden Schäden hervorgerufen, die sehr sicher mit dem beschriebenen Verfahren detektiert werden können. Demnach ist das erfindungsgemäße Verfahren zwar auch sehr gut geeignet für die Bauteil- oder Baugruppen-Prüfung nach der Fertigung, vorteilhafterweise wird es auch basierend auf den Ergebnissen einer Prüfung nach Fertigung zur Alterungsvorhersage und Ausfallrisikoabschätzung herangezogen. Besonders vorteilhaft am Verfahren ist dessen Einsatzmöglichkeit im Betrieb des elektronischen Bauelements oder der elektronischen Baugruppe. Eine im Betrieb vornehmbare Prüfung und auch wiederholt vornehmbare Prüfung birgt besondere Vorteile für eine daraus ableitbare Alterungsvorhersage beziehungsweise Ausfallrisikoabschätzung.

Unter einer elektronischen Baugruppe ist insbesondere eine leistungselektronische Baugruppe zu verstehen, z.B. ein Leistungsmodul. Eine elektronische Baugruppe umfasst wenigstens ein Bauteil, insbesondere ein Halbleiter-Bauelement, z.B. einen Leistungsschalter. Der Aufbau einer elektronischen Baugruppe umfasst demnach unterschiedliche Schichten und allgemein unterschiedliche Materialien, welche auch mittels unterschiedlicher Herstellungsverfahren erzeugt und zusammengefügt werden. Unter materiellen Änderungen können Schäden, Delaminationen, Risse, und allgemein Materialalterung verstanden werden.

Typische Bauelemente der Leistungselektronik sind beispielsweise: bipolare Leistungstransistoren wie Schaltnetzteile und DC/DC-Wandler, Leistungs-MOSFET, IGBTs, insbesondere Schaltnetzteile, Motorsteuerungen und Umrichter, außerdem Thyristoren, insbesondere Stromrichter, Halbleiterrelais, Impulsstromquellen, Ansteuerungen von Thyristoren, GTO-Thyristoren, das sind Stromrichter großer Leistung, des Weiteren Triacs, insbesondere Dimmer oder Halbleiterrelais, außerdem Dioden zur Gleichrichtung und als Freilaufdioden beispielsweise Schottkydioden oder Siliziumdioden, schließlich Leistungskondensatoren.

Einsatzgebiete der Leistungselektronik können beispielsweise sein, Schaltnetzteile, Frequenzumrichter, Hochfrequenzgeneratoren, Gleichstromsteller, Phasenanschnittsteuerungen, Hochspannungs-Gleichstromübertragung, Wechselrichter oder Halbleiter-Relais.

Ein weiterer Vorteil des erfindungsgemäßen Verfahrens liegt beispielsweise darin, dass die Messung nicht nur während des Betriebs und wiederholt während des Betriebs möglich ist, sondern sogar eine kontinuierliche Messung der Alterung ermöglicht wird. So kann der Zustand eines gesamten Modulaufbaus kontinuierlich im Betrieb gemessen werden können, und es können notwendige Maßnahmen daraus abgeleitet werden. Diese Lösung ist kommerziell einsetzbar für die Zustandsüberwachung von gesamten Leistungsmodulen in Umrichtern. Das angegebene Qualitätsprüfungsverfahren ist im Hinblick auf eine Lebensdauerprognose belastbar.

Das Verfahren ermöglicht eine verbesserte, nicht-destruktive, verlässlichere, im Bauteilbetrieb vornehmbare Detektion von alterungsbedingten Schäden oder Delaminationen an einer leistungselektronischen Baugruppe sowie an einzelnen Bauteilen dieser Baugruppe, insbesondere Leistungsmodulen leistungselektronischer Geräte.

Das erfindungsgemäße Verfahren zur Qualitätsprüfung einer leistungselektronischen Baugruppe hat des Weiteren den Vorteil, dass die Baugruppe und Bauteile der Baugruppe auch an optisch nicht zugänglichen Bereichen auf Fertigungsfehler nach der Bestückung untersucht werden kann.

Bevorzugt wird als elektrisches Charakterisierungsverfahren die Impedanzspektroskopie verwendet. In einer vorteilhaften Ausgestaltung des Verfahrens wird demnach wenigstens ein Bauteil der leistungselektronischen Baugruppe durch Messen mindestens eines Impedanzspektrums des Bauteils und dessen Änderung infolge der Ultraschallanregung untersucht. Mittels der Signalanalyse werden die Impedanzspektren verglichen, wobei festgestellte Veränderungen Schäden oder Delaminationen am Bauteil indizieren. Insbesondere wirkt die Signalanalyse mit der Messung funktional zusammen: Die Messung der frequenzabhängigen Impedanz erfolgt vergleichend einmal mit und einmal ohne zusätzlich US-Anregung. Die Differenzsignale werden ausgewertet.

Bei der elektrischen Verzerrungsmessung kommt es aufgrund von nichtlinearen elektrischen, thermischen und mechanischen Eigenschaften bei der Hochfrequenzübertragung in leistungselektronischen Systemen zur Erzeugung von Hochfrequenzsignalen, die von der ursprünglichen Frequenz deutlich abweichen. Es werden dabei Frequenzsignale erzeugt, die einem Vielfachen der Ursprungsfrequenz oder bei Einspeisung mehrerer Frequenzen einer Differenz- oder Summenfrequenz entsprechen.

In einer vorteilhaften Ausgestaltung des Verfahrens werden die Ultraschallwellen mittels elektrischer Anregung erzeugt. Beispielsweise wird mittels elektrischer Anregung ein Ultraschallsignal in das zu charakterisierende Bauteil, beziehungsweise in die Baugruppe eigekoppelt. An den Grenzflächen der Verbindungsschichten (Lot, Bond o.ä.) kommt es dann zu elektrischen Verzerrungen durch nichtlineare Effekte basierend auf lokale Temperaturen, mechanische Delaminationen und elektrische Übergangswiderstände.

In einer weiteren vorteilhaften Ausgestaltung des erfindungsgemäßen Verfahrens werden die Ultraschall-Signalanteile auf das intermodulierte elektrische Signal moduliert. Mit elektrischem Signal ist das Ausgangssignal des elektrischen Charakterisierungsverfahrens gemeint. Hierdurch ergibt sich insbesondere der Vorteil, dass Fehler im getesteten Aufbau zunächst verstärkt und dadurch besser erkennbar werden.

Vorteilhafterweise wird bei dem erfindungsgemäßen Verfahren in einer seiner Ausführungsformen eine Signalanalyse vorgenommen, mittels welcher thermo-mechanische Anteile und mechanische Anteile des Verschleißes getrennt werden. Dies ist möglich, da durch das Ultraschall-Signal vor allem die mechanischen Signale verstärkt werden, welche die Hinweise auf Defekte geben.

In einer weiteren vorteilhaften Ausgestaltung des erfindungsgemäßen Verfahrens wird eine leistungselektronische Baugruppe untersucht, welche einen planaren Aufbau hat, und die Ultraschallwellen werden mittels eines Ultraschallerzeugers erzeugt, welcher direkt auf der planaren AVT aufsetzt. Unter AVT ist ein planarer Aufbau in der Aufbau- und Verbindungstechnik zu verstehen. Besonders bevorzugt ist dabei der Einsatz eines Ultraschallerzeugers im Verfahren, welcher direkt in den planaren Aufbau integriert ist, insbesondere als piezoelektrische Schicht. In einer dieser beschriebenen Ausführungsformen werden beispielsweise die Ultraschallwellen als oberflächennahe Welle in die leistungselektronische Baugruppe eingekoppelt werden.

Alternativ oder zusätzlich können in einer weiteren vorteilhaften Ausgestaltung des erfindungsgemäßen Verfahrens die Ultraschallwellen als Volumenwelle innerhalb der leistungselektronische Baugruppe erzeugt werden. Insbesondere werden die Ultraschallwellen dazu an mehreren Positionen der leistungselektronischen Baugruppe erzeugt. Es gibt dazu insbesondere mehrere Ultraschallerzeuger im planaren Aufbau.

In einer weiteren bevorzugten Ausführungsform des Verfahrens wird die leistungselektronische Baugruppe kontinuierlich oder einmalig oder zu diskreten Zeitpunkten in Ultraschallschwingungen versetzt.

Die erfindungsgemäße leistungselektronische Baugruppe, insbesondere ein Schaltungsträger, ist ausgestaltet, ein wie vorstehend beschriebenes erfindungsgemäßes auszuführen. Dazu umfasst die Baugruppe wenigstens eine Ultraschallquelle, welche eingerichtet und angeordnet ist, die leistungselektronische Baugruppe in Ultraschallschwingungen zu versetzen, eine Messeinrichtung, welche ausgestaltet ist, eine elektrische Charakterisierung, insbesondere eine frequenzabhängige Impedanzmessung vorzunehmen, und eine Auswerteinrichtung, welche ausgebildet ist, mittels der erfassten elektrischen Signaländerung auf einen Defekt der elektronischen Baugruppe zu schließen.

Die leistungselektronische Baugruppe ist insbesondere ein Schaltungsträger, d.h. mindestens ein Bauteil der Baugruppe ist ein Leistungsschalter.

Als Messeinrichtung, welche ausgestaltet ist, eine frequenzabhängige Impedanzmessung vorzunehmen, kann beispielsweise ein Spektrumanalyzer oder Lock-In-Verstärker dienen

In einer vorteilhaften Ausgestaltung der Erfindung weist die erfindungsgemäße leistungselektronische Baugruppe einen planaren Aufbau hat und umfasst einen Ultraschallerzeuger, welcher direkt auf der planaren AVT aufsetzt. Für die oberflächennahe Ultraschallsignal-Einstrahlung kann beispielsweise ein Piezoaktor oder eine Sonotrode benutzt werden.

In einer alternativen vorteilhaften Ausgestaltung der Erfindung weist die erfindungsgemäße leistungselektronische Baugruppe einen planaren Aufbau auf und umfasst einen Ultraschallerzeuger, welcher in den planaren Aufbau integriert ist, insbesondere als piezoelektrische Schicht. Bevorzugt dienen Siliziumcarbid-Halbleiter oder Siliziumcarbid-MOS (Metal oxide semiconductors) oder Galliumnitrid als Ultraschallerzeuger.

In einer weiteren vorteilhaften Ausgestaltung der Erfindung weist die erfindungsgemäße leistungselektronische Baugruppe alternativ oder zusätzlich einen Ultraschallerzeuger auf, welcher in ein Bauelement der leistungselektronischen Baugruppe integriert ist, welches piezoelektrische Eigenschaften aufweist, insbesondere als piezoelektrische Schicht. Das heißt wenigstens ein Ultraschallerzeuger ist umfasst, welcher in weiterer Funktion ein Bauelement der leistungselektronischen Baugruppe darstellt, welches Bauelement eine piezoelektrische Schicht umfasst.

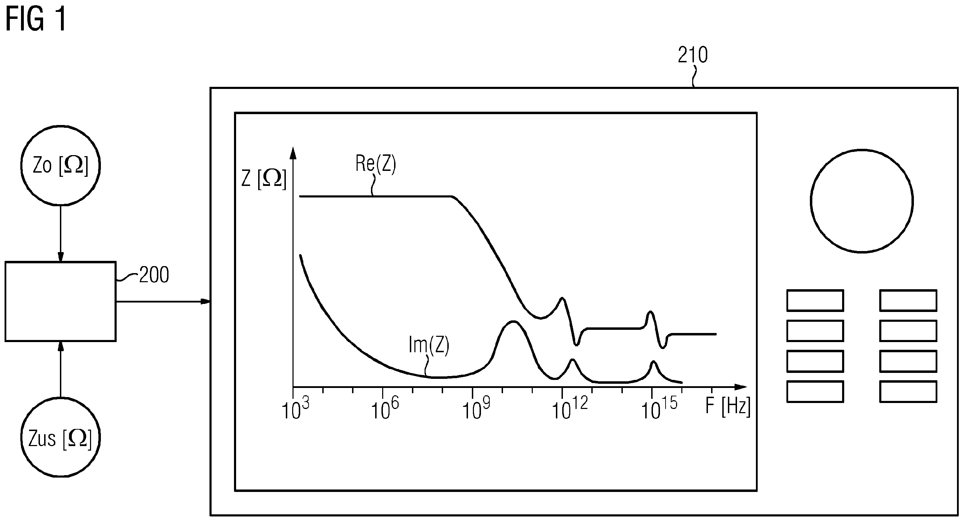

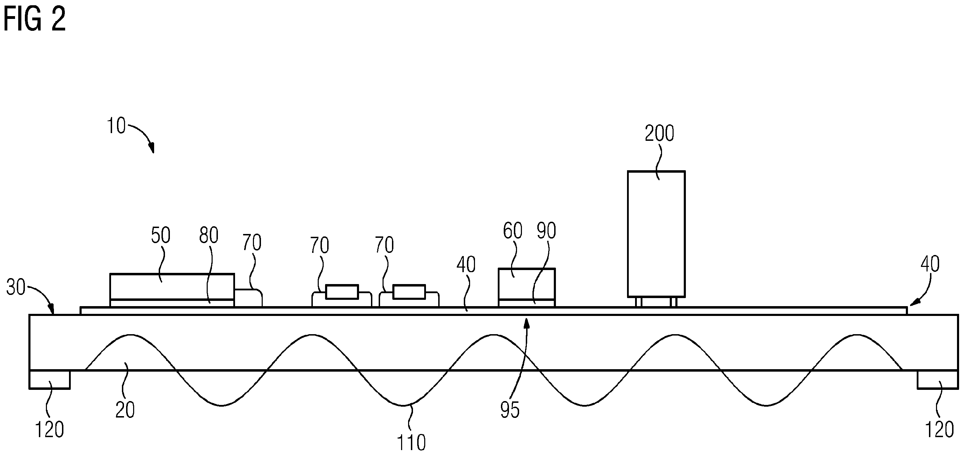

Beispiele und Ausführungsformen der vorliegenden Erfindung werden noch in exemplarischer Weise mit Bezug auf die Figuren 1 und 2 der angehängten Zeichnung beschrieben:
Figur 1 zeigt schematisch ein Ablaufdiagramm der Messsignalauswertung des erfindungsgemäßen Verfahrens,
Figur 2 zeigt schematisch eine Baugruppe mit entsprechenden Vorrichtungen zur Durchführung des erfindungsgemäßen Verfahrens.

Bei dem erfindungsgemäßen Verfahren zur Prüfung einer elektronischen Baugruppe 10 wird die elektronische Baugruppe 10 in Ultraschallschwingungen 110 versetzt. Ultraschallschwingungen 110 erstrecken sich regelmäßig über einen Frequenzbereich von 10 bis 300 kHz. Gleichzeitig wird die elektronischen Baugruppe 10 mittels eines elektrischen Charakterisierungsverfahrens, insbesondere Impedanzspektroskopie, untersucht. Bevorzugt wird bei dem erfindungsgemäßen Verfahren das durch Ultraschallschwingungen 110 veränderte Impedanzspektrum Zᵤₛ [Ω] der elektronischen Baugruppe 10, oder nur einer elektronischen Anbindung 80, 90 oder das eines Bauteils 50, 60 erfasst und herangezogen, um auf einen Defekt zu schließen. Für die Auswertung 210 wird das veränderte Impedanzspektrum Zᵤₛ [Ω] mit dem Impedanzspektrum ohne Ultraschallanregung Zₒ [Ω] verglichen, wie schematisch im Ablaufdiagramm der Fig. 1 gezeigt. Diese Messsignalauswertung findet bevorzugt in einer Auswerteeinheit 210 statt, welche ausgestaltet ist die elektrischen Messsignale aufzunehmen und auswerten. Mittels des angegebenen Verfahrens können vorteilhaft elektronische Baugruppen 10 auf Defekte, wie insbesondere auf lokale Fehlstellen 95, geprüft werden, welche mit optischen oder elektronischen Verfahren, wie sie aus dem Stand der Technik bekannt sind, nicht erfasst werden können.

Bevorzugt wird bei dem erfindungsgemäßen Verfahren die elektronische Baugruppe 10 einmalig in Ultraschallschwingungen 110 versetzt. Zweckmäßig wird dazu die elektronische Baugruppe 10 mittels eines zeitlich begrenzten Ultraschallwellenzuges angeregt und so in Schwingung versetzt. Alternativ und ebenfalls bevorzugt kann die elektronische Baugruppe 10 zu diskreten Zeitpunkten wiederholt in Ultraschallschwingungen versetzt werden. Beispielsweise kommen dazu mehrere zeitlich lokalisierte Ultraschallwellenzüge zum Einsatz. Auf diese Weise lassen sich auch abklingende Ultraschallschwingungen 110 der elektronischen Baugruppe 10 auswerten. Insbesondere aus abklingenden Ultraschallschwingungen 110 können Informationen über lokale Dämpfungen und Eigenresonanzen erhalten werden. Alternativ oder zusätzlich kann die elektronische Baugruppe 10 auch kontinuierlich in Ultraschallschwingungen 110 versetzt werden. So lassen sich insbesondere Änderungen der Resonanzfrequenzen von Eigenschwingungen der elektronischen Baugruppe 10 oder Teilen der elektronischen Baugruppe 50, 60, 80, 90 heranziehen, um auf das Vorhandensein von Defekten und/oder auf den Ort 95 von solchen Defekten zu schließen. Bevorzugt wird bei dem erfindungsgemäßen Verfahren die elektronische Baugruppe 10 an mehreren Bereichen 120 der elektronischen Baugruppe 10 in Ultraschallschwingungen 110 versetzt. So kann ein Versetzen der elektronischen Baugruppe 10 an mehreren Bereichen der elektronischen Baugruppe 10 in Ultraschallschwingungen 110 Informationen über eine räumliche Lokalisierung von Defekten 95 geben. Zudem kann vorteilhaft sichergestellt werden, dass sämtliche relevanten Eigenschwingungen der elektronischen Baugruppe 10 angeregt werden, wenn die elektronische Baugruppe 10 nicht nur ein einem einzigen Bereich in Ultraschallschwingungen 110 versetzt wird. Die Zuverlässigkeit des erfindungsgemäßen Verfahrens wird in dieser Weiterbildung folglich weiter erhöht.

Insbesondere fehlerhafte Anbindungen 80, 90 von unterschiedlichen Materialien haben ein verändertes Schwingungsverhalten der elektronischen Baugruppe 10 bei Ultraschallschwingungen 110 zur Folge. Besonders eine großflächige Lötverbindung 80, 90 von Bauteilen 50, 60 oder Laserverschweißungen von Lastanschlüssen weisen im Falle von Defekten ein verändertes Schwingungsverhalten auf. Auch und gerade defektbehaftete Metallisierungen 40 von Schaltungsträgern 20 oder Verwölbungen von Schaltungsträgern 20 lassen sich leicht mittels des erfindungsgemäßen Verfahrens erfassen. Mittels des erfindungsgemäßen Verfahrens ist folglich eine besonders zuverlässige Prüfung elektronischer Baugruppen 10 möglich.

Beispielsweise ist die elektronische Baugruppe 10 ein Schaltungsträger, oder die elektronische Baugruppe weist einen Schaltungsträger 20 auf. Eine elektronische Baugruppe 10 ist häufig aus verschiedenen Bauelementen 50, 60, beziehungsweise Bauteilen und dementsprechend aus verschiedenen Materialien, insbesondere Materialien der Aufbau- und Verbindungstechnik, zusammengesetzt, bei welchen Materialien Defekte in Form von Hohlräumen, Rissen oder partiellen Ablösungen der Verbindung regelmäßig auftreten. Auf diese Weise kann gerade in diesem wichtigen Fall der Schaltungsträger 20 umfassenden elektronischen Baugruppen 10 eine Prüfung auf Defekte zuverlässig und effizient erfolgen.

Fig. 2 zeigt schematisch eine Prinzipskizze einer elektronischen Baugruppe 10, welche angeordnet und ausgebildet ist, ein erfindungsgemäßes Verfahren zur Prüfung der elektronischen Baugruppe 10 auszuführen. Die elektronische Baugruppe 10 umfasst beispielsweise eine Ultraschallquelle 120, welche eingerichtet und angeordnet ist, um die elektronische Baugruppe 10 in Ultraschallschwingungen 110 zu ersetzen. Zudem umfasst die elektronische Baugruppe 10 eine Vorrichtung 200 zur Durchführung einer Impedanzmessung beziehungsweise elektrische Kontakte zur Anbindung einer Vorrichtung 200 zur Durchführung einer Impedanzmessung. Eine Auswerteinrichtung 210, welche nicht in Fig. 2 dargestellt ist, da sie nicht zwingend mit der Baugruppe 10 baulich verbunden sein muss, schließt mittels der ultraschallwellenbeeinflussten Impedanzspektroskopie Zᵤₛ [Ω] auf einen Defekt 95 der elektronischen Baugruppe 10.

Bevorzugt wird das Verfahren zur Prüfung einer elektronischen Baugruppe in Gestalt eines Leistungsmoduls 10 durchgeführt. Das Leistungsmodul 10 weist einen Schaltungsträger in Gestalt einer Leiterplatte 20 auf, welcher als Flachteil mit einer Flachseite 30 ausgebildet ist. An der Flachseite 30 ist eine Kupfermetallisierung in Gestalt einer flächig angebundenen Kupferschicht 40 befindlich. An die Kupferschicht 40 sind Halbleiterbauelemente 50, 60 sowie ein Lastanschluss 70 angebunden. Die Halbleiterbauelemente 50, 60 sind mittels Lötschichten 80, 90 an die Kupfermetallisierung 40 angebunden. Der Lastanschluss 70 ist mittels einer Laserschweißung 100 an die Kupfermetallisierung 40 geschweißt. Bei den Lötschichten 80, 90, mittels welchen die Halbleiterbauelemente 50, 60 an die Kupfermetallisierung 40 angebunden sind sowie bei der Laserverschweißung 100, mittels welcher der Lastanschluss 70 an die Kupfermetallisierung 40 angebunden ist, treten Defekte in Form von Hohlräumen, wie insbesondere Lunker oder Delaminationen auf. Zur Prüfung des Leistungsmoduls 10 auf diese Defekte wird das Leistungsmodul 10 in Ultraschallschwingungen 110 versetzt. Dazu sind Ultraschallquellen 120 vorgesehen, welche Ultraschallwellen 130 in Richtung 140 senkrecht zur Flachseite 30 auf eine der Flachseite 30 abgewandte Seite der Leiterplatte 20 auf die Leiterplatte 20 einstrahlen. Dabei sind die Ultraschallquellen 120 in den flächigen Erstreckungsrichtungen der Flachseite 30 betrachtet an voneinander entfernten Enden der Flachseite 30 der Leiterplatte 20 angeordnet. Das Leistungsmodul 10 wird also an mehreren Bereichen in Ultraschallschwingungen 110 versetzt.

Eine Alterung im Leistungsmodul macht sich durch ein verändertes Schwingungsverhalten der Bonddrähte 70 und gelöteten Chips 50, 60 bemerkbar, da sich diese Verbindungen 80, 90 durch Delamination lockern. Die Schwingungsbelastung durch den Ultraschall 110 greift an solchen Delaminationen an, verstärkt die Signale und erzeugt insbesondere zusätzliche Signale, wenn Delaminationen auftreten und anwachsen. So können z.B. bei Rissen die US-Anteile auf das elektrische Signal moduliert werden. Durch eine Signalanalyse 210 können die thermischen Anteile und die mechanischen Anteile getrennt werden. Dies kann besonders vorteilhaft bei einer planaren Aufbau-und Verbindungstechnik (AVT) eingesetzt werden, da ein US-Sender 1250 leicht in den planaren Aufbau einkoppeln kann. Der US-Sender 120 sitzt dann auf der planaren AVT und kann die Ultraschallwellen 110 in den planaren Aufbau einkoppeln. Der US-Sender 120 umfasst piezoelektrische Schichten, welche auch in der planaren Aufbau- und Verbindungstechnik integriert werden können. Hierbei ist zu beachten, dass der Ultraschall 110 sowohl als oberflächennahe Welle eingekoppelt werden kann, aber auch als Volumenwelle im zu untersuchenden Bauteil erzeugt werden kann.

Besonders vorteilhaft kann ein Leistungsbauteil 50, 60 selbst als US-Sender 120 und Empfänger fungieren, da insbesondere SiC- und GaN-Halbleiter piezoelektrische Eigenschaften besitzen.

Auch dann liegen die Ultraschallsender 120 im Leistungsmodul 10 integriert vor. Durch entsprechende elektrische Anregungen kann das Bauteil 50, 60 Ultraschallsignale 110 aussenden und rücklaufende Signale detektieren. Die zusätzliche mechanische Stimulierung mittels Ultraschall 110 kann besonders einfach bei planaren Aufbauten erreicht werden kann. Hierdurch können Delaminationen und Risse besser erkannt werden. Vorteilhaft gegenüber bisherigen Prüfungsverfahren, wie beispielsweise der HF-Reflektometrie, ist das vorgeschlagene Verfahren drahtgebunden, bei deutlich niedrigeren Frequenzen. Piezoaktoren zur US-Stimulierung 120 können direkt in der planaren Aufbautechnik integriert werden bzw. die Leistungsbauteile 50, 60 selbst übernehmen diese Funktion. Ein weiterer Vorteil ist die hohe Messgenauigkeit, gegebenenfalls mit Ortsauflösung, je nach dem, wieviele und wie verteilt die Ultraschallerzeuger 120 und Sensoren eingesetzt werden. Des Weiteren ist die vorgeschlagene Messtechnik relativ kostengünstig und das vorgeschlagene Verfahren ermöglicht eine frühzeitige Detektion von Umfang und Art einer thermomechanischen Alterung.

### Bezugszeichenliste:

- 110: Ultraschallschwingungen
- 120: Ultraschallquelle, z.B. elektrisch anregbare piezoelektrische Schicht
- 130: Ultraschallwellen
- 140: Richtung der Ultraschallwellen
- 10: elektronische Baugruppe, Leistungsmodul
- 20: Leiterplatte
- 30: Flachseite
- 40: Kupferschicht
- 50: Halbleiterbauelement
- 60: Halbleiterbauelement
- 70: Bonddrähte, Lötverbindungen
- 80: Lötschicht
- 90: Lötschicht
- 95: lokale Fehlstelle
- 100: Laserschweißung
- Zᵤₛ [Ω]: Impedanz bei Ultraschallanregung
- Zₒ [Ω]: Impedanz ohne Ultraschallanregung
- 200: Empfangseinheit, Messeinheit für Impedanz
- 210: Auswerteeinheit

## Patentansprüche

1. Verfahren zur Qualitätsprüfung einer leistungselektronischen Baugruppe (10), bei dem wenigstens ein Bauteil der leistungselektronischen Baugruppe (10) mittels eines elektrischen Charakterisierungsverfahrens untersucht wird, wobei das untersuchte Bauteil mittels Ultraschallwellen (130) derart angeregt wird, dass dadurch Veränderungen im Signal des elektrischen Charakterisierungsverfahrens verursacht werden, welche mittels einer Signalanalyse (210) ausgewertet werden und welche materielle Änderungen am Bauteil indizieren.

2. Verfahren nach Anspruch 1, wobei das elektrische Charakterisierungsverfahren eine Impedanzspektroskopie ist und wobei mittels der Signalanalyse (210) die Impedanzspektren verglichen werden, wobei festgestellte Veränderungen des Impedanzspektrums Schäden oder Delaminationen am Bauteil indizieren.

3. Verfahren nach Anspruch 1 oder 2, wobei die Ultraschallwellen (130) mittels elektrischer Anregung erzeugt werden.

4. Verfahren nach einem der vorstehenden Ansprüche, wobei die Ultraschall-Signalanteile auf das intermodulierte elektrische Signal moduliert werden.

5. Verfahren nach einem der vorstehenden Ansprüche, bei dem eine Signalanalyse vorgenommen wird, mittels welcher thermo-mechanische Anteile und mechanische Anteile des Verschleißes getrennt werden.

6. Verfahren nach einem der vorstehenden Ansprüche, wobei die leistungselektronische Baugruppe (10) einen planaren Aufbau hat, und wobei die Ultraschallwellen (130) mittels eines Ultraschallerzeugers (120) erzeugt werden, welcher direkt auf der planaren AVT aufsetzt.

7. Verfahren nach dem vorstehenden Anspruch 5, wobei der Ultraschallerzeuger (120) in den planaren Aufbau integriert ist, insbesondere als piezoelektrische Schicht.

8. Verfahren nach einem der vorstehenden Ansprüche 6 oder 7, wobei die Ultraschallwellen (130) als oberflächennahe Welle in die leistungselektronische Baugruppe (10) eingekoppelt werden.

9. Verfahren nach einem der vorstehenden Ansprüche, wobei die Ultraschallwellen (130) als Volumenwelle innerhalb der leistungselektronische Baugruppe (10) erzeugt werden.

10. Verfahren nach einem der vorstehenden Ansprüche, wobei die leistungselektronische Baugruppe (10) kontinuierlich oder einmalig oder zu diskreten Zeitpunkten in Ultraschallschwingungen (110) versetzt wird.

11. Leistungselektronische Baugruppe (10), insbesondere Schaltungsträger, welche ausgestaltet ist, ein Verfahren nach einem der vorhergehenden Ansprüche auszuführen,
umfassend wenigstens eine Ultraschallquelle (120), welche eingerichtet und angeordnet ist, die leistungselektronische Baugruppe (10) in Ultraschallschwingungen (110) zu versetzen, umfassend eine Messeinrichtung (200), welche ausgestaltet ist eine elektrische Charakterisierung, insbesondere eine frequenzabhängige Impedanzmessung vorzunehmen, umfassend eine Auswerteinrichtung (210), welche ausgebildet ist, mittels der erfassten elektrischen Signaländerung auf einen Defekt der elektronischen Baugruppe (10) zu schließen.

12. Leistungselektronische Baugruppe (10) nach Anspruch 11, welche einen planaren Aufbau hat und einen Ultraschallerzeuger aufweist, welcher direkt auf der planaren AVT aufsetzt.

13. Leistungselektronische Baugruppe (10) nach einem der vorstehenden Ansprüche 11 oder 12, welche einen planaren Aufbau hat und einen Ultraschallerzeuger aufweist, welcher in den planaren Aufbau integriert ist, insbesondere als piezoelektrische Schicht.

14. Leistungselektronische Baugruppe (10) nach einem der vorstehenden Ansprüche 11 bis 13, welche einen Ultraschallerzeuger aufweist, welcher in ein Bauelement der leistungselektronischen Baugruppe (10) integriert ist, welches piezoelektrische Eigenschaften aufweist, insbesondere als piezoelektrische Schicht.
